(19)

**Europäisches Patentamt**
**European Patent Office**
**Office européen des brevets**

(11) **EP 4 160 337 A1**

(12) **EUROPEAN PATENT APPLICATION**

(43) Date of publication:
05.04.2023 Bulletin 2023/14

(21) Application number: 21200190.3

(22) Date of filing: 30.09.2021

(51) International Patent Classification (IPC):
**G05B 23/02** (2006.01) **G01M 13/04** (2006.01)

(52) Cooperative Patent Classification (CPC):
**G05B 23/0283; G01M 13/04;** G05B 2219/37351;
G05B 2219/37434; G05B 2219/42328

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Aktiengesellschaft**
**80333 München (DE)**

(72) Inventors:
• **NAIR, Sudev**
**560078 Bangalore, Karnataka (IN)**
• **VERMA, Taneshq**
**110054 Timarpur, New Delhi (IN)**

(74) Representative: **Isarpatent**
**Patent- und Rechtsanwälte Barth**
**Charles Hassa Peckmann & Partner mbB**
**Friedrichstrasse 31**
**80801 München (DE)**

(54) **SYSTEM AND METHOD FOR ESTIMATING REMAINING USEFUL LIFE OF A BEARING**

(57) A system and method for estimating remaining useful life of a bearing (105) is disclosed. The method comprises receiving, by a processing unit, operational data associated with the bearing (105) from at least one source in real-time. Further, one or more failure modes associated with the bearing (105) are determined based on one or more features associated with the operational data. Based on the one or more features, a best-suited virtual model corresponding to the bearing (105) is identified from a plurality of virtual models. Each of the virtual models indicates a behavior of the bearing (105) for a predefined set of conditions. Further, a remaining useful life of the bearing (105) is computed based on the best-suited virtual model.

FIG 1A

EP 4 160 337 A1

**Description**

The present invention relates to remaining useful life estimation, and more particularly relates to a system and method for estimating remaining useful life of bearings.

Bearings are used in several machinery in an industry for the purpose of reducing friction between two rotating parts. These bearings also restrict relative motion between the rotating parts to a desired motion. However, bearings may fail unexpectedly due to factors such as poor lubrication and contamination within a structure of the bearing. For example, lubrication within the bearing may fail during an operational phase of the bearing due to excessive temperatures. Contamination may occur due to entry of foreign particles, moisture etc. into the structure of the bearing. The above factors may lead to failure modes such as corrosion, spalling, pitting, electrical erosion, plastic deformation and so on, in the bearing. As a result, an expected fatigue life of the bearing is reduced and eventually resulting in failures. Consequently, bearing failures may cause unexpected downtime of the machinery, resulting in production and financial loss. Accurate predictions of bearing failures can help prevent unexpected downtimes. However, estimating remaining useful life of a bearing is challenging due to the difficulties in estimating effects of contamination and lubrication. Further, the remaining useful life also varies based on application and design of the bearing.

In light of the above, there exists a need for a system and method for estimating remaining useful life of a bearing based on a scenario associated with the bearing. The term 'scenario' as used herein may refer to various factors including such as applications, design and other operating conditions such as ambient temperature, lubrication type etc.

Disclosed herein is a method for estimating remaining useful life of a bearing, in accordance with an embodiment of the present invention. The method comprises receiving operational data associated with the bearing from at least one source in real-time. In an embodiment, the operational data comprises at least one of temperature signature, vibration signature, current signature and angular velocity associated with the bearing.

The method further comprises determining one or more failure modes associated with the bearing based on one or more features associated with the operational data. In an embodiment, the step of determining the one or more failure modes associated with the bearing comprises analyzing the operational data using a plurality of signal processing pipelines. Each of the signal processing pipelines generate a response indicative of the one or more features associated with the operational data. Further, the one or more features from the response are classified into one or more failure modes using a classification model.

Advantageously, use of a plurality of signal processing pipelines enables determination of multiple features associated with the operational data.

The method further comprises identifying a best-suited virtual model corresponding to the bearing from a plurality of virtual models, based on the one or more features. Each of the virtual models indicates a behavior of the bearing for a predefined set of conditions. In an embodiment, the step of identifying the best-suited virtual model corresponding to the bearing comprises updating the plurality of virtual models based on the one or more features and corresponding failure modes. Further, simulation instances are based on each of the updated virtual models. The simulation instances are further executed in the simulation environment to generate simulation results. Further, the best-suited virtual model is identified based on the simulation results. In a further embodiment, the step of identifying the best-suited virtual model comprises computing a reliability coefficient associated with each of the virtual models. Further, the virtual model corresponding to the highest reliability coefficient is selected as the best-suited virtual model.

Advantageously, the present invention dynamically selects a best-suited virtual model for the bearing from a plurality of virtual models, based on real-time operational data. In other words, the bearing model is continuously adapted based on real-time behavior of the bearing. Consequently, manual efforts required in configuring a bearing model is reduced.

The method further comprises computing a remaining useful life of the bearing based on the best-suited virtual model. In an embodiment, the step of computing the remaining useful life of the bearing comprises determining one or more key performance indicators associated with the bearing using the best-suited virtual model. Further, the remaining useful life is computed based on the one or more key performance indicators determined. In a further embodiment, the method comprises outputting the remaining useful life in real-time on an output device.

Advantageously, the present invention computes remaining useful life of the bearing in real-time based on the best-suited virtual model. Therefore, if additional failure modes occur a new best-suited virtual model is selected and updated to estimate the real-time key performance indicators.

Disclosed herein is also an apparatus for estimating remaining useful life of a bearing, in accordance with an embodiment of the present invention. The apparatus comprises one or more processing units, and a memory unit communicatively coupled to the one or more processing units. The memory unit comprises a bearing monitoring module stored in the form of machine-readable instructions executable by the one or more processing units. The bearing monitoring module is configured to perform method steps described above.

Disclosed herein is also a system for estimating remaining useful life of a bearing, in accordance with an embodiment of the present invention. The system comprises one or more sources capable of providing operational data associated with a bearing and an apparatus as described above, communicatively coupled to the one or more sources. The term 'sources' as used herein, refer to electronic devices configured to obtain and transmit the operational data to the apparatus. Non-limiting examples of sources include sensing units, controllers and edge devices.

The object of the present invention is also achieved by a computer-readable medium, on which program code sections of a computer program are saved, the program code sections being loadable into and/or executable by a processor which performs the method as described above when the program code sections are executed.

The realization of the invention by a computer program product and/or a non-transitory computer-readable storage medium has the advantage that computer systems can be easily adopted by installing computer program in order to work as proposed by the present invention.

The computer program product can be, for example, a computer program or comprise another element apart from the computer program. This other element can be hardware, for example a memory device, on which the computer program is stored, a hardware key for using the computer program and the like, and/or software, for example a documentation or a software key for using the computer program.

The above-mentioned attributes, features, and advantages of the present invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:

FIG 1        illustrates a block diagram of a system for estimating remaining useful life of a bearing, in accordance with an embodiment of the present invention;

FIGS 2A      illustrate structure of a ball bearing;

FIG 2B       illustrates a defect in the ball bearing;

FIG 3        shows a flowchart of a method for estimating remaining useful life of a bearing, in accordance with an embodiment of the present invention;

FIG 4        shows a diagrammatic representation of processing of a vibrational signature using a plurality of signal processing pipelines, in accordance with an embodiment of the present invention;

FIG 5        illustrates a block diagram of a signal processing pipeline in accordance with an exemplary embodiment of the present invention;

FIG 6        illustrates a workflow representing selection of a best-suited virtual model, in accordance with an embodiment of the present invention; and

FIG 7        shows a representation of a convolutional neural network, in accordance with an embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

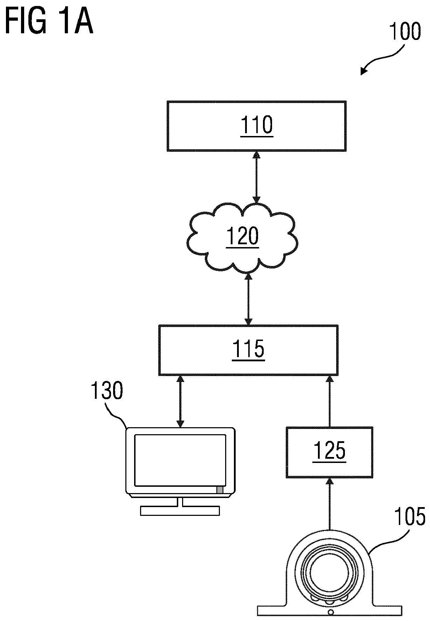

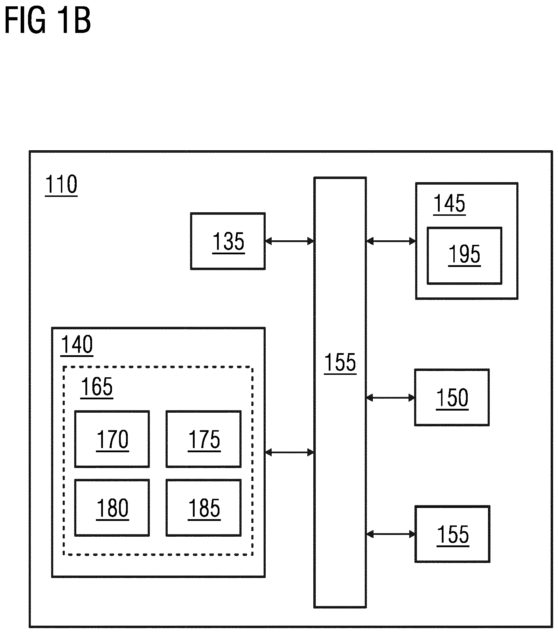

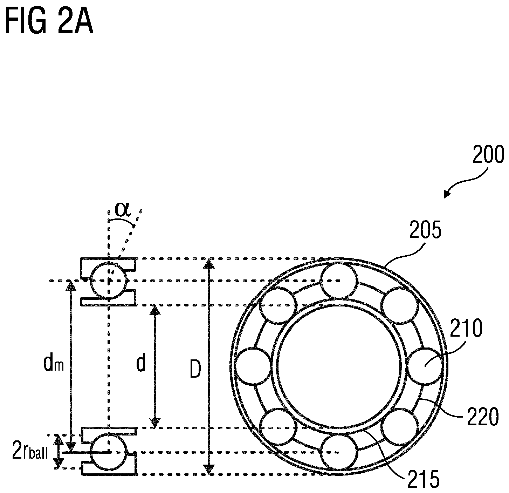

FIG 1 illustrates a block diagram of a system 100 for estimating remaining useful life of a bearing 105, in accordance with an embodiment of the present invention. In the present disclosure, the term 'bearing' is used to refer to an assembly comprising an outer race, cage, rolling elements, inner race and shield that are mounted on a rotating shaft. Non-limiting examples of bearings include deep groove ball bearings, cylindrical roller bearings, a tapered roller bearing, thrust bearing, angular contact ball bearing, needle ball bearing and the like. In the present embodiment, the system is configured to estimate remaining useful life of ball bearings. In the present embodiment, the bearing 105 comprises an inner race, an outer race and a plurality of rolling elements disposed in a gap between the inner race and the outer race. The bearing 105 further comprises a cage positioned between the inner race and the outer race for maintaining a symmetric radial gap between the rolling elements. An example of a bearing is described later in the present disclosure with reference to FIG 2A.

The system 100 comprises an apparatus 110 communicatively coupled to one or more edge devices 115. The one or more edge devices 115 are connected to the apparatus 110 via a network 120, for example, local area network (LAN), wide area network (WAN), Wi-Fi, etc. Each of the edge devices 115 is configured to receive operational data from at least one sensing unit 125 associated with the bearing 105.

The sensing unit 125 generates an output signal indicative of an operational parameter associated with the bearing 105 in real-time. In an embodiment, the sensing unit 125 may include a vibration sensor configured to generate a vibration signature corresponding to vibrations in the bearing 105. The vibration signature may include a time-domain acceleration signal. In another embodiment, the sensing unit 125 may include a temperature sensor configured to generate a temperature signature associated with the bearing 105. The temperature signature may include a time-domain temperature signal. In another embodiment, the sensing unit 125 may include a current sensor such as a current transformer, configured to obtain a current signature associated with the bearing 105. The current signature includes a time-series current signal. The sensing unit 125 is further communicatively coupled to the apparatus. In yet another embodiment, the sensing unit 125 may include a speed sensor configured to obtain an angular velocity associated with the bearing 105. In an embodiment, the operational data are obtained through data acquisition interfaces on the edge device 115. The edge device 115 provides the operational data in real-time to the apparatus 110.

In addition, the edge device 115 is also configured to provide one or more bearing parameters associated with the bearing 105 to the apparatus 110. The one or more bearing parameters include, but are not limited to, a standard bearing number, a ball size, bearing static load, density of material, angular velocity, internal clearance, bearing diameter, number of rolling elements, radius of rolling element, diameter of inner race, diameter of outer race, fatigue load limit, and type of lubricant used in the bearing 105. It must be understood that the standard bearing number is indicative of certain specifications such as a ball size, bearing static load, density of material, internal clearance, bearing diameter, number of rolling elements, radius of rolling element, diameter of inner race, diameter of outer race, fatigue load limit, bearing width and the like, as provided by a manufacturer of the bearing 105. Therefore, in an embodiment, the standard bearing number associated with the bearing 105 may be provided in place of the above bearing parameters.

The one or more bearing parameters may be stored in a memory of the edge device 115 or may be input to the edge device 115 by an operator. For example, the edge device 115 may be communicatively coupled to a client device 130. Non-limiting examples of client devices include, personal computers, workstations, personal digital assistants, human machine interfaces. The client device 130 may enable the user to input values for the one or more bearing parameters through a web-based interface. Upon receiving the one or more bearing parameters from the user, the edge device 115 transmits a request for analyzing a defect in the bearing 105 to the apparatus 110. The defects occur due to initiation of a failure mode in the bearing 105. Non-limiting examples of failure modes include spalling, pitting, plastic deformation, abrasion, electrical erosion and corrosion typically on an outer race of the bearing 105. The defects may occur due to presence of contaminants or due to properties of a lubricant used within the bearing 105. The request comprises the one or more bearing parameters along with the operational data.

In the present embodiment, the apparatus 110 is deployed in a cloud computing environment. As used herein, "cloud computing environment" refers to a processing environment comprising configurable computing physical and logical resources, for example, networks, servers, storage, applications, services, etc., and data distributed over the network 120, for example, the internet. The cloud computing environment provides on-demand network access to a shared pool of the configurable computing physical and logical resources. The apparatus 110 may include a module that estimates remaining useful life of a given bearing based on the corresponding operational data and the one or more bearing parameters. Additionally, the apparatus 110 may include a network interface for communicating with the one or more edge devices 115 via the network 120.

The apparatus 110 comprises a processing unit 135, a memory unit 140, a storage unit 145, a communication unit 150, the network interface 155 and a standard interface or bus 160, as shown in FIG 1B. The apparatus 110 can be a computer, a workstation, a virtual machine running on host hardware, a microcontroller, or an integrated circuit. As an alternative, the apparatus 110 can be a real or a virtual group of computers (the technical term for a real group of computers is "cluster", the technical term for a virtual group of computers is "cloud").

The term 'processing unit' 135, as used herein, means any type of computational circuit, such as, but not limited to, a microprocessor, microcontroller, complex instruction set computing microprocessor, reduced instruction set computing microprocessor, very long instruction word microprocessor, explicitly parallel instruction computing microprocessor, graphics processor, digital signal processor, or any other type of processing circuit. The processing unit 135 may also include embedded controllers, such as generic or programmable logic devices or arrays, application specific integrated circuits, single-chip computers, and the like. In general, a processing unit 135 may comprise hardware elements and software elements. The processing unit 135 can be configured for multithreading, i.e., the processing unit 135 may host different calculation processes at the same time, executing the either in parallel or switching between active and passive calculation processes.

The memory unit 140 may be volatile memory and non-volatile memory. The memory unit 140 may be coupled for communication with the processing unit 135. The processing unit 135 may execute instructions and/or code stored in the memory unit 140. A variety of computer-readable storage media may be stored in and accessed from the memory unit 140. The memory unit 140 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

The memory unit 140 comprises a bearing monitoring module 165 in the form of machine-readable instructions on any of the above-mentioned storage media and may be in communication to and executed by the processing unit 135. The bearing monitoring module 165 comprises an analysis module 170, a model identification module 175, a life estimation module 180 and a notification module 185. The analysis module 170 determines one or more failure modes associated with the bearing based on one or more features associated with the operational data. The model identification module 175 is configured for identifying a best-suited virtual model corresponding to the bearing from a plurality of virtual models based on the one or more features. Each of the virtual models indicates a behavior of the bearing for a predefined set of conditions. The life estimation module 180 is configured for computing a remaining useful life of the bearing based on the best-suited virtual model. The notification module 185 is configured for outputting the computed remaining useful life of the bearing 105 on an output device. In the present embodiment, the output device may be the client device 130.

The storage unit 145 comprises a non-volatile memory which stores default bearing parameters associated with standard bearing numbers. The storage unit 145 includes a database 195 that comprises default values of bearing parameters and one or more look-up tables comprising predetermined values for factors that vary with operating conditions of the bearing 105. The bus 160 acts as interconnect between the processing unit 135, the memory unit 140, the storage unit, and the network interface 155. The communication unit 150 enables the apparatus 110 to receive requests from the one or more edge devices 115. The communication module may support different standard communication protocols such as Transport Control Protocol/Internet Protocol (TCP/IP), Profinet, Profibus, and Internet Protocol Version (IPv).

Those of ordinary skilled in the art will appreciate that the hardware depicted in FIG 1A and 1B may vary for different implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter, network connectivity devices also may be used in addition or in place of the hardware depicted. The depicted example is provided for the purpose of explanation only and is not meant to imply architectural limitations with respect to the present disclosure.

FIG 2A illustrates structure of a ball bearing 200. The ball bearing 200 comprises an outer race 210 of diameter D, a plurality of balls 215 each of radius $r_{ball}$, a cage 220 and an inner race 225 of diameter d. The plurality of balls 215 are disposed in a gap between the outer race 210 and the inner race 225. The cage 220 maintains a symmetric radial spacing between the balls 215. $\alpha$ is the angle of contact between the ball and the outer race. Here, $d_m$ is the pitch diameter of the bearing 200.

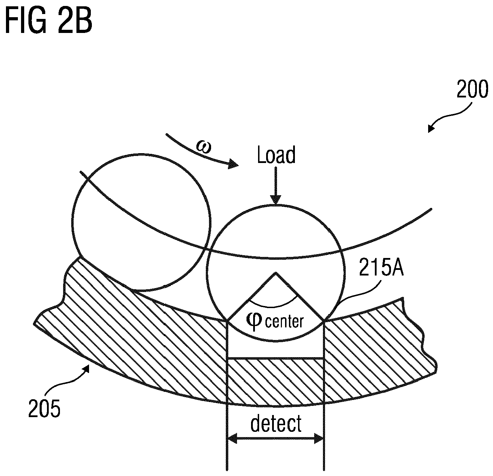

FIG 2B illustrates a defect of defect size $d_{defect}$ on a wall of the outer race 210 in contact with the balls 210. In the present example, the defect is an indentation in the outer race 210 due to pitting. The defect size may be defined as a distance travelled by a ball of the ball bearing 200 between entering and leaving the defect. The defect subtends an angle $\theta_{center}$ at the center of a ball 215A among the plurality of balls 215 as shown.

Similarly, defects may be also form in the inner race of the bearing. The defects may be due to misalignment, eccentricity, loose foot, contamination, lubrication etc. Each of the faults is associated with one or more characteristic frequencies in a vibration signature associated with the bearing. The characteristic frequencies may be predetermined based on correlations derived based on experimental data generated corresponding to each of the defects.

In an embodiment, defects are artificially introduced into a component of the bearing or a similar bearing in order to emulate effects of the fault. Further, vibration signatures associated with the defected component is measured using vibration sensors. The vibration signatures are analyzed in frequency domain in order to establish correlations between the fault and failing frequencies in the vibration signature. For example, misalignments in the bearing may be indicated by peak amplitudes at 3x frequencies in a Fast Fourier Transform of the vibration signature. Similarly, correlations between fault in a component of the bearing and corresponding failing frequencies are predetermined through experimentation. For example, defects in the outer race is characterized by presence of Ball Pass Frequency of Outer race (BPFO) generated when a ball comes in contact with the defect on the outer race, where:

$$\text{BPFO (Hz)} = S \left(\frac{N}{2}\right) \left(1 - \frac{B}{P}\cos\beta\right) \tag{1}$$

where B is diameter of the ball, P is the pitch diameter, N is the number of balls in the bearing, S is the angular velocity of the bearing in Hz and $\beta$ is the contact angle associated with the defect.

Similarly, defects in the inner race is characterized by Ball Pass Frequency of Inner race (BPFI) generated when a ball comes in contact with the defect in the inner race, where:

$$\text{BPFI (Hz)} = S \; \left(\frac{N}{2}\right) \; \left(1 + \frac{B}{P}\cos\beta\right) \qquad\qquad (2)$$

Likewise, defects in the cage is characterized by train or cage frequency generated when a ball comes in contact with the defect in the cage, where:

$$\text{Train or Cage Frequency (Hz)} = S \; \left(\frac{1}{2}\right) \; \left(1 - \frac{B}{P}\cos\beta\right) \qquad (3)$$

Further, defects in a ball of the bearing is characterized by ball spin frequency generated when a defected ball touches the outer race or the inner race, where:

$$\text{Ball Spin Frequency (Hz)} = S \; \left(\frac{P}{2B}\right) \; \left(1 - \frac{B^2}{P^2}(\cos\beta)^2\right) \qquad (4)$$

As shown, each of the failing frequencies mentioned above are dependent on bearing dimensions and the angular velocity of the bearing. Each of the defects is indicated by presence of harmonics around the failing frequencies in a frequency spectrum corresponding to the vibration spectrum.

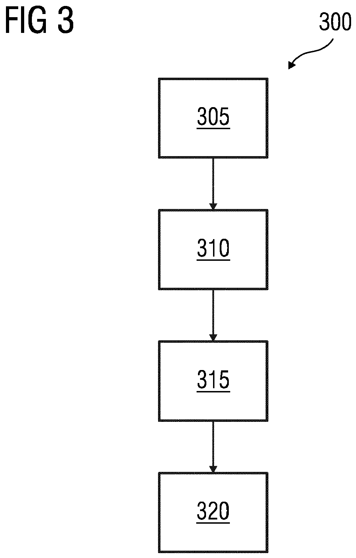

FIG 3 shows a flowchart of a method 300 for estimating remaining useful life of a bearing, in accordance with an embodiment of the present invention. The remaining useful life of the bearing is estimated based on defects present in the bearing.

At step 305, operational data from at least one sensing unit associated with the bearing is received in real-time. The operational data comprises a time-domain signal generated by the sensing unit. The operational data may include, but not limited to, vibration signature, current signature and temperature signature. In the present embodiment, the operational data comprises a vibration signature, hereinafter referred as 'the signal'. In an embodiment, the current signature may be further analysed, using Motor Current Signature Analysis, to determine frequencies corresponding to the vibration signature that may occur due to dynamic eccentricity of the shaft.

At step 310, one or more failure modes associated with the bearing is determined based on one or more features associated with the operational data. In the present embodiment, the failure modes are determined by firstly analyzing the operational data using a plurality of signal processing pipelines. Each of the signal processing pipelines generate a response indicative of the one or more features associated with the operational data. The features may include, for example, peak amplitudes, root mean square values, crest, time duration between events, modified crest, failure frequencies, harmonics, side bands, kurtosis etc. It must be understood by a person skilled in the art that in addition to the above-mentioned features, statistical measures such as standard deviation, mean value etc associated with the operational data may also be determined using the signal processing pipelines.

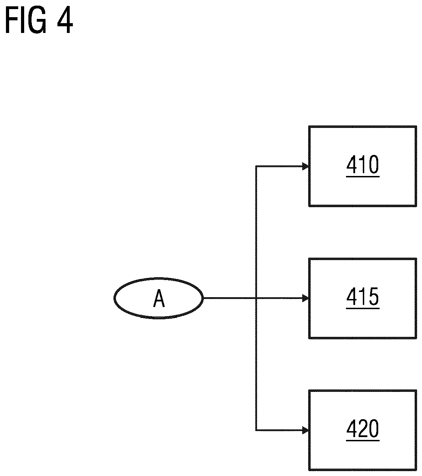

In an embodiment, each of the signal processing pipelines is associated with at least one signal processing function. The signal processing functions may include, but not limited to, bandpass filtering, envelope analysis, Child Wavelet Transform (CWT), Discrete Wavelet Transform (DWT), Fast Fourier Transform (FFT), Short-time Fourier transform (STFT), Spectral Kurtosis (SK) and Fast Kurtogram. In addition, the signal processing pipelines may also include signal preprocessing functions such as denoising algorithms, bandwidth filtering etc. In the present embodiment, three signal processing pipelines corresponding to FFT, CWT and DWT are used. FIG 4 shows a diagrammatic representation of processing of a vibrational signature A using a first signal processing pipeline 410 corresponding to FFT, a second signal processing pipeline 415 corresponding to CWT and a third signal processing pipeline 420 corresponding to DWT.

In particular, FFT decomposes vibrational signal in time-domain into infinite number of sine or cosine waves in frequency domain. Advantageously, FFT helps in determining events from stationary signals. The term 'stationary signal' as used herein refers to a signal wave that has a constant time period and spectral content value. In an embodiment, the FFT helps in determining defect size associated with a defect based on the instances at which a ball associated with the bearing experiences an impact force due to the defect.

Wavelet transforms such as CWT and DWT are used for transforming the time-domain signal from the sensing unit into another time-domain signal. In other words, wavelet transforms involve breaking up of a signal into shifted and scaled versions of the original signal. When applied to a transient or non-stationary signal, wavelet transforms help in determining features associated with the operational data that vary with time. The wavelet transform is performed by correlating an input signal x(t) with a wavelet basis. For example, wavelet transform of signal x(t) is given by,

$$W(a, b) \quad = \quad \int_{-\infty}^{+\infty} x(t) \frac{1}{\sqrt{a}} \Psi_{a,b}(t) \, dt \qquad (5)$$

where $W(a, b)$ represent wavelet coefficients, $\psi(t)$ is a mother wavelet, a is dilation (scale) parameter and b is translation (position) parameter. The more dilated and translated wavelets are similar to the signal at different levels of resolution, the larger the corresponding wavelet coefficients become. The wavelet coefficients therefore, facilitate extraction of features associated with the signal. The mother wavelet is a waveform of limited duration that has an average value of zero and is represented as:

$$\Psi_{a,b}(t) \quad = \quad \frac{1}{\sqrt{a}} \psi^* \left( \frac{t-a}{b} \right) \qquad (6)$$

The dilation (scale) parameter 'a' and the translation (position) parameter 'b' play a vital role in wavelet transform. The dilation parameter causes the signal to be dilated by a factor of 'a'. Dilated wavelets help in capturing slowly varying low frequency changes and compressed wavelets help in capturing abrupt, high frequency changes. The translation parameter causes the signal to be time-shifted by a factor of 'b' along the time-axis. The translation parameter shifts the wavelet in order to align the wavelet with features of interest in the signal.

DWT uses filter banks for analysis and synthesis of a signal. Each of the filter banks contains wavelet filters that help in extracting the frequency content of the signal in various sub bands. In an implementation, the DWT is derived by discretization of the CWT of the signal in dyadic scale, followed by translation. Consequently, the computational time associated with the DWT is reduced. The DWT may be expressed using the following equation:

$$DWT(a, b) \quad = \quad \int_{-\infty}^{+\infty} x(t) \frac{1}{\sqrt{a}} \psi^* \left( \frac{t-a}{b} \right) dt \qquad (7)$$

The original signal x(t) passes through a set of low pass and high pass filters emerging as low frequency and high frequency signals at a decomposition level 'n'. Therefore, the original signal x(t) can be written as:

$$X(t) \quad = \quad a(n) \quad + \quad \sum_{i=1}^{n} d(i) \qquad (8)$$

DWT helps in calculating the defect size from the signal. More specifically, the defect size on the outer race of the bearing can be estimated based on duration between entry and exit events corresponding to a ball with respect the defect. The entry event corresponds to the instant at which a ball of the bearing comes in contact with a leading edge of the defect. The exit event corresponds to the instant at which the same ball comes in contact with a trailing edge of the bearing. The events are extracted from the signal after decomposition using DWT. The duration between the events is used to estimate the defect size as follows:

$$Defect\ Size = \frac{P * S}{4} \left( 1 - \frac{B^2}{P^2} (\cos \beta)^2 \right) * \Delta t \qquad (9)$$

where S is the angular velocity, D is the pitch diameter of the bearing, B is the ball diameter, $\beta$ is the contact angle and $\Delta t$ is the duration between the entry and exit events. The contact angle is usually taken as zero for for deep groove ball bearings.

In an implementation, the decomposition is performed by using symlets, such as sym5, as mother wavelets. The scaling filters associated with symlets are near-linear phase filters. Consequently, phase response of the scaling filters is a linear function of frequency. This enables symlets to deal with small discontinuities present in the signal without major loss of information. As a result, symlets may be used in both CWT and DWT.

In the present embodiment, each of the three signal processing pipelines 410, 415, and 420 generate responses indicative of the one or more features. In particular, FFT provides indication of events associated with the ball coming in contact with a defect. CWT provides indication of fault modes such as misalignment as well as cyclicity associated with impact force generated when a ball comes in contact with the defect. For example, CWT of a healthy bearing is typically plain, while patterns in the CWT indicate presence of defects. DWT provides indication of fault modes similar to CWT.

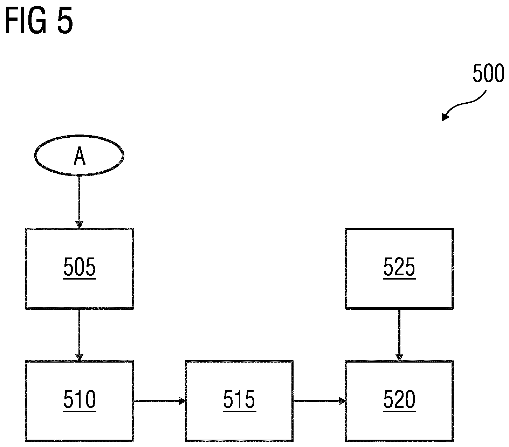

Similarly, a signal processing pipeline may also include a combination of signal preprocessing and post-processing functions as shown in FIG 5.

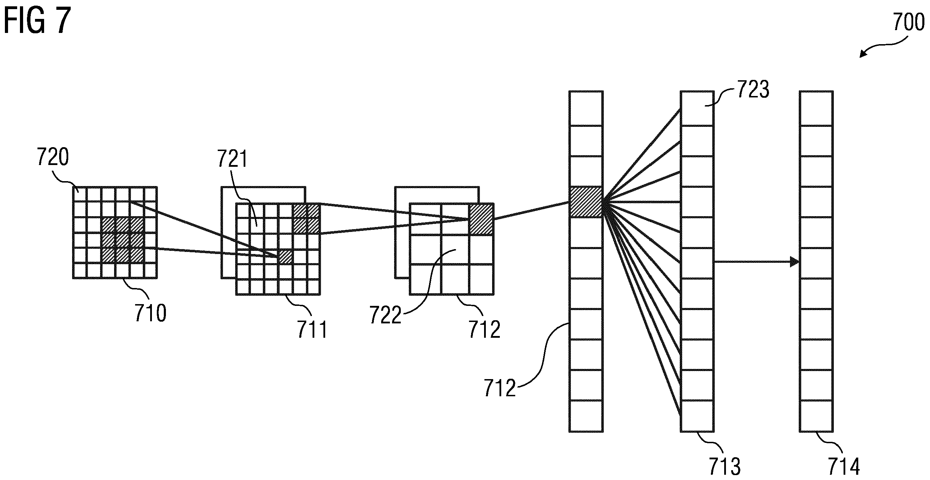

Further, the one or more features are classified into one or more failure modes using a classification model. The failure modes may be associated with, for example, lubrication-related anomalies, contamination-related anomalies, eccentricity, misalignment and loose foot. In the present embodiment, the classification model is a convolutional neural network (CNN). The structure of a CNN is explained in detail using FIG 7.

At step 315, a best-suited virtual model corresponding to the bearing is identified from a plurality of virtual models. Each of the virtual models indicates a behavior of the bearing for a predefined set of conditions. The predefined set of conditions may be associated with, but not limited to, application (low speed, high speed or medium speed) of the bearing, design of the bearing, nature of bearing support, damping and coupler design. In other words, each of the virtual models may correspond to a different behavioral model associated with the bearing.

In the present example, the bearing is mounted on a shaft associated with a motor coupled to a pump. A coupler may be provided between the bearing and the shaft of the motor. However, stiffness of the coupler may vary based on factors in-eluding, but not limited to, application (low speed, high speed or medium speed), nature of bearing support, damping and coupler design. Consequently, the bearing may exhibit varying behavior in different scenarios. In an embodiment, each of the virtual models may be digital twins of the bearings. Each of the digital twins may be built and calibrated based on experimental data and simulation data corresponding to, for example, different applications, damping, coupler designs, faults etc.

The best-suited virtual model is identified by firstly updating the virtual models based on the one or more features and corresponding failure modes. In addition to the one or more features, the virtual model is also updated based on the bearing parameters corresponding to the bearing. Upon updating, simulation instances corresponding to each of the virtual models are generated. The simulation instances may be associated with one or more of 1D simulation, 2D simulation, 3D simulation, co-simulation, discrete simulation, continuous simulation, stochastic simulations and so on.

The simulation instances are further executed in a suitable simulation environment. Upon execution of the simulation instances, simulation results are generated. The simulation results correspond to outputs from each of the virtual models. For example, one or more of the simulation results may indicate a maximum impact force experienced by a ball due to a defect. The simulation results may further include a reliability coefficient corresponding to each of the virtual models. The reliability coefficient is determined based on variances associated with outputs from each of the virtual models using statistical techniques known in the art. In an embodiment, the reliability coefficient is determined using artificial intelligence models trained using test data and simulation data for identifying reliability coefficients, along with optimisation models.

Further, the virtual model corresponding to highest reliability coefficient is selected as the best-suited virtual model.

At step 320, a remaining useful life of the bearing is predicted based on the best-suited virtual model. The term 'remaining useful life' as used herein, refers to a duration between initiation of a detectable failure mode and a functional failure of the bearing. The remaining useful life is computed based on a key performance indicator estimated by the best-suited virtual model. The key performance indicators are characteristic to the application of the bearing and behaviour of the bearing with respect to the application. For example, the key performance indicator is a dynamic load on the bearing. In another example, the key performance indicator is a contact force or contact stress associated with a rolling element of the bearing upon coming in contact with the defect.

In an example, the remaining useful life may be expressed as number of revolutions before the failure occurs. In another example, the remaining useful life is expressed as number of operating hours at a constant speed before the failure. In a preferred embodiment, the remaining useful life $L_{RUL}$ for the bearing is determined based on the following rating life model:

$$L_{10} \ = \ a_1 a_{iso} \left(\frac{C}{P}\right)^3 \qquad\qquad (10)$$

where, $a_{iso}$ is a life modification factor based on systems approach for life calculation given by:

$$a_{iso} = f\left(\frac{e_c C_u}{P}, K\right) \qquad\qquad (11)$$

where, $a_1$ is a life modification factor for reliability, $C_u$ is fatigue load limit in Newtons, $e_c$ is a contamination factor specific to the defect size, $P$ is dynamic equivalent radial load in Newtons, $C$ is dynamic equivalent radial load rating, K is viscosity ratio.

The life modification factor for reliability is a predefined value specified in ISO 281:2007 for a given value of reliability. For example, if the reliability may be considered to be 90%, a1 is taken as 1. The value of reliability is taken as 90% by default. In an embodiment of the present invention, the value of reliability may be modified by an operator through the client device. The life modification factor for reliability may be further obtained from a first lookup table stored in the database, based on the value of reliability. The fatigue load limit and the dynamic equivalent radial load rating are obtained from the one or more bearing parameters associated with the bearing.

The contamination factor is determined based on the defect size. This is because, defects in the bearing result in removal of small, discrete particles of material from the structure of the bearing. These discrete particles increase the concentration of contaminants inside the bearing. The concentration of contaminations further increases with increase in the defect size. The defect size is provided as input to a trained classification model that classifies the defect size into one of a plurality of severity levels. For example, the plurality of severity levels may correspond to 'normal cleanliness', 'slight to typical contamination', 'severe contamination' and 'very severe contamination'. Based on the defect size, the trained classification model outputs a severity level. The severity level thus determined is further used to select an appropriate contamination factor from a second lookup table. The second lookup table may comprise values of contamination factor corresponding to each of the severity levels. It must be understood by a person skilled in the art that the classification model may be trained to classify the defect size into one of any number of severity levels.

The viscosity ratio is indicative of a lubrication condition of the bearing during operation. The viscosity ratio is calculated as the ratio of an operating viscosity of the lubricant to a rated viscosity of the lubricant. The operating viscosity is calculated based on a viscosity grade of the lubricant and an operating temperature. The viscosity grade of the oil may be obtained from a third look up table comprising viscosity grades corresponding to different types of lubricants. In one embodiment, the operating temperature of the bearing may be obtained from temperature sensors associated with the bearing. In another embodiment, a virtual model of the bearing may be used to determine a thermal profile of the bearing based on the operational data. The rated viscosity is obtained from a fourth look up table based on dimensions of the bearing and angular velocity of the bearing.

The equation (15) for rating life may be rearranged to obtain the remaining useful life model below:

$$L_{10} = a_1 f\left(\frac{e_c C_u}{P}, K\right)\left(\frac{C}{P}\right)^3 \qquad (12)$$

Here, the dynamic equivalent radial load P is the same as the maximum impact force computed by the best-suited virtual model. Therefore, the remaining useful life is a function of the dynamic equivalent radial load P. In an embodiment, the best-suited virtual model determines the maximum impact force based on mathematical model of the bearing, the experimental data and the simulation data corresponding to operational behaviour of the bearing. Therefore, the remaining useful life of the bearing may be estimated as a function of the mathematical model, the experimental data and the simulation data.

$$L_{RUL} = a_1 f\left(\frac{e_c C_u}{G\{Mathematical\ model,\ simulation\ data,\ experimental\ data\}}, K\right)\left(\frac{C}{P}\right)^3 \qquad (13)$$

The mathematical model of the bearing is of the form:

$$p_1 \frac{k_c}{m_b} x_{imax}^{5/2} - p_2 \frac{Q_\varphi}{m_b} \cos\left(\frac{\theta_b}{2}\right) x_{imax} = (r_b \omega_f \sin\theta_b)^2 \qquad (14)$$

which can be rearranged as:

$$p_1 \frac{k_c}{m_b} x_{imax}^5 - [p_2 \frac{Q_\varphi}{m_b}\cos\left(\frac{\theta_b}{2}\right)]^2 x_{imax}^2 - 2(r_b \omega_f \sin\theta_b)^2 [p_2 \frac{Q_\varphi}{m_b}\cos\left(\frac{\theta_b}{2}\right)] x_{imax} - (r_b \omega_f \sin\theta_b)^4 = 0$$

$$(15)$$

where, $x_{imax}$ is a maximum deflection of the ball in mm;

$$k_c = 4E_{eq}^2 \frac{\sqrt{r_{eq}}}{3} \qquad (16)$$

$$E_{eq} = \frac{E}{1-v^2} \qquad (17)$$

where $v$ is Poisson's ratio associated with a material of the bearing, $E$ is Young's modulus associated with material and $E_{eq}$ is equivalent stiffness of the material. For example, if the bearing is made of EN31 steel, the Poisson's ratio is 0.3 and Young's modulus is 210 GPa.

$$r_{eq} = 0.5098 * r_{ball} \qquad (18)$$

where $r_{ball}$ is the radius of the ball

$$Q_\varphi = Load * 4.37 \qquad (19)$$

$$\theta_b = \sin^{-1} \frac{defect\ size}{2\ r_{ball}} \qquad (20)$$

$$\theta_a = \sin^{-1} \frac{defect\ size}{2\ r_{bearing}} \qquad (21)$$

where $r_{bearing}$ is a radius of the bearing given by:

$$r_{bearing} = d_m + internal\ clearance/2 \qquad (22)$$

$$\omega_f = \sqrt[2]{\frac{10Q_\varphi(\theta_b - \theta_a)\sin\frac{\theta_b}{2}}{7} + \omega^2} \qquad (23)$$

where $\omega$ is angular velocity is the angular frequency with which the ball rotates about the edge of the defect.

In the above equation, parameters p1 and p2 are tuned based on the bearing parameters. In an embodiment, the parameters are tuned using a trained machine learning model. The trained machine learning model is an evolutionary algorithm. The mathematical model is further solved for $x_{imax}$. Further, the maximum impact force $F_{max}$ on the ball is calculated from $x_{imax}$ according to the following equation:

$$F_{max} = k_c x_{imax}^{3/2} \qquad (24)$$

Here $F_{max}$ represents the value of maximum impact force on the ball calculated mathematically.

The bearing life thus calculated is further outputted as a notification on the output device. notification that indicates the remaining useful life of the bearing as a dynamically changing parameter based on the best-suited virtual model selected. For example, the notification may include a message *The remaining useful life of bearing 6319 is 56 hours'.*

FIG 5 illustrates a block diagram 500 of a signal processing pipeline in accordance with an exemplary embodiment of the present invention. Here, a vibration signature A is firstly processed using a CWT function 505. Further, a response from the CWT function 505 is processed using an SK function 510. The SK function 510 detects presence of transients and their locations in the frequency domain. Further, a passband is selected from the output of the SK function 510 using a bandpass filter 515. The output of the bandpass filter 515 is further processed using a Hilbert Transform function 520. The Hilbert Transform function 520 helps in obtaining a minimum-phase response from the spectral analysis performed using the SK function 510. The output of the Hilbert Transform function 520 is further processed using CWT/FFT function 525. The output of the CWT/FFT function 525 may be further analyzed to determine the BPFO of the bearing.

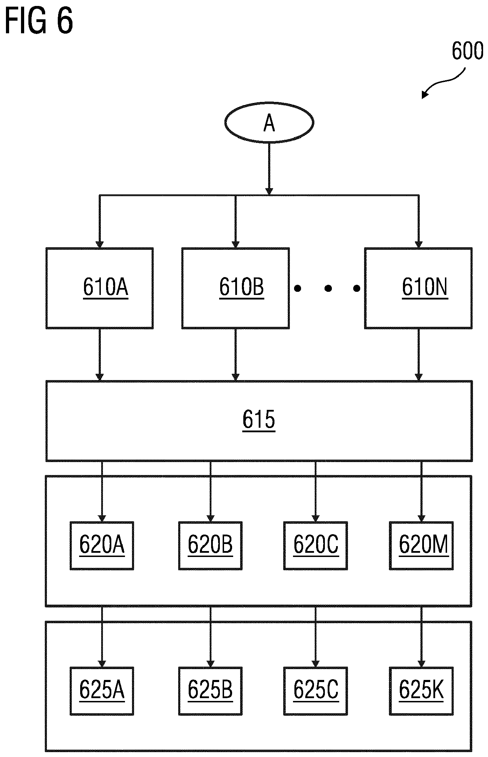

FIG 6 illustrates a workflow 600 representing selection of a best-suited virtual model, in accordance with an embodiment of the present invention. The workflow 600 comprises a plurality of signal processing pipelines 610A, 610B..610N (collectively called signal processing pipelines 610) for processing a vibration signature A. The responses from each of the signal processing pipelines 610 are further processed using an overlaying classification model 615. Further, a plurality of virtual models 620A, 620B..620M (collectively called virtual models 620) are updated based on failure modes identified using the classification model 615 and features corresponding to the failure modes. Outputs from the updated virtual models 620A, 620B..620M are further analyzed to identify the best-suited virtual model from the virtual models 620. For example, the best-suited virtual model may be virtual model 620B. Further, one or more of key performance indicators 625A, 625B...625K (collectively called key performance indicators 625) required for computation of the remaining useful life are identified using the best-suited virtual model.

FIG 7 shows a representation of a convolutional neural network 700, in accordance with an embodiment of the present invention. Examples of CNN may include, but are not limited to, Fast Region based CNN (Fast R-CNN), Faster Region based CNN (or Faster R-CNN), Mask Region based CNN (or Mask R-CNN) and You Only Look Once (YOLO). In the displayed embodiment, the convolutional neural network 700 comprises an input layer 710, a convolutional layer 711, a pooling layer 712, a fully connected layer 713 and an output layer 714. Alternatively, the convolutional neural network 700 may comprise several convolutional layers 711, several pooling layers 712 and several fully connected layers 713, as well as other types of layers. The order of the layers may be chosen arbitrarily. In an exemplary implementation, fully connected layers 713 are used as the last layers before the output layer 714.

In the convolutional neural network 700, the nodes 720, ..., 724 of layers 710, ..., 714 may be considered to be arranged as a d-dimensional matrix or as a d-dimensional image. In particular, in the two-dimensional case, the value of the node 720, ..., 724 indexed with i and j in the n-th layer 710, ..., 714 may be denoted as $x^{(n)}[i,j]$. However, the arrangement of the nodes 720, ..., 724 of one layer 710, ..., 714 does not have an effect on the calculations executed within the convolutional neural network 700 since these are given solely by the structure and the weights of the edges.

In particular, a convolutional layer 711 is characterized by the structure and the weights of the incoming edges forming a convolution operation based on a certain number of kernels. In particular, the structure and the weights of the incoming edges are chosen such that the values $x^{(n)}_k$ of the nodes 721 of the convolutional layer 711 are calculated as a convolution $x^{(n)}_k = K_k * x^{(n-1)}$ based on the values $x^{(n-1)}$ of the nodes 720 of the preceding layer 710, where the convolution* is defined in the two-dimensional case as:

$$x_k^{(n)}[i,j] = (K_k * x^{(n-1)})[i,j] = \sum_{i'} \sum_{j'} K_k[i',j'] \cdot x^{(n-1)}[i-i',j-j']$$

Here the k-th kernel $K_k$ is a d-dimensional matrix (in the present embodiment, a two-dimensional matrix), which is usually small compared to the number of nodes 720, ..., 724 (e.g. a 3x3 matrix, or a 5x5 matrix). In particular, this implies that the weights of the incoming edges are not independent but chosen such that they produce said convolution equation. In particular, for a kernel being a 3x3 matrix, there are only 9 independent weights (each entry of the kernel matrix corresponding to one independent weight), irrespectively of the number of nodes 720, ..., 724 in the respective layer 710, ..., 714. In particular, for a convolutional layer 711, the number of nodes 721 in the convolutional layer is equivalent to the number of nodes 720 in the preceding layer 710 multiplied with the number of kernels.

If the nodes 720 of the preceding layer 710 are arranged as a d-dimensional matrix using a plurality of kernels may be interpreted as adding a further dimension (denoted as "depth" dimension), so that the nodes 721 of the convolutional layer 721 are arranged as a (d+1)-dimensional matrix. If the nodes 720 of the preceding layer 710 are already arranged as a (d+1)-dimensional matrix comprising a depth dimension using a plurality of kernels may be interpreted as expanding along the depth dimension so that the nodes 721 of the convolutional layer 721 are arranged also as a (d+1)-dimensional matrix. The size of the (d+1)-dimensional matrix with respect to the depth dimension is by a factor of the number of kernels larger than in the preceding layer 710.

The advantage of using convolutional layers 711 is that spatially local correlation of the input data may exploited by enforcing a local connectivity pattern between nodes of adjacent layers, in particular by each node being connected to only a small region of the nodes of the preceding layer.

In the displayed embodiment, the input layer 710 comprises 36 nodes 720 arranged as a two-dimensional 6x6 matrix. The convolutional layer 711 comprises 72 nodes 721, arranged as two two-dimensional 6x6 matrices, each of the two matrices being the result of a convolution of the values of the input layer with a kernel. Equivalently, the nodes 721 of the convolutional layer 711 may be interpreted as arranges as a three-dimensional 6x6x2 matrix, wherein the last dimension is the depth dimension.

The pooling layer 712 may be characterized by the structure and the weights of the incoming edges and the activation function of its nodes 722 forming a pooling operation based on a non-linear pooling function f. For example, in the two-dimensional case the values $x^{(n)}$ of the nodes 722 of the pooling layer 712 may be calculated based on the values $x^{(n-1)}$ of the nodes 721 of the preceding layer 711 as $x^{(n)}[i,j]= f(x^{(n-1)}[id_1, jd_2], ..., x^{(n-1)}[id_1+d_1-1, jd_2+d_2-1])$. In other words, the number of nodes 721, 722 may be reduced by using the pooling layer 712, by replacing a number $d_1 \cdot d_2$ of neighboring nodes 721 in the preceding layer 711 with a single node 722 being calculated as a function of the values of said number of neighboring nodes in the pooling layer. In particular, the pooling function f may be the max-function, the average or the L2-Norm. In particular, for the pooling layer 712, the weights of the incoming edges are fixed and are not modified by training.

The advantage of using the pooling layer 712 is that the number of nodes 721, 722 and the number of parameters is reduced. This leads to the amount of computation in the convolutional neural network 700 being reduced and to a control of overfitting.

In the displayed embodiment, the pooling layer 712 is a max-pooling, replacing four neighboring nodes with only one node, the value being the maximum of the values of the four neighboring nodes. The max-pooling is applied to each d-dimensional matrix of the previous layer. In the present embodiment, the max-pooling is applied to each of the two two-dimensional matrices, reducing the number of nodes from 72 to 18.

The fully-connected layer 713 may be characterized by the fact that a majority, in particular, all edges between nodes 722 of the previous layer 712 and the nodes 723 of the fully-connected layer 713 are present, and wherein the weight of each of the edges may be adjusted individually.

In the present embodiment, the nodes 722 of the preceding layer 712 of the fully-connected layer 713 are displayed both as two-dimensional matrices, and additionally as non-related nodes (indicated as a line of nodes, wherein the number of nodes was reduced for a better presentability).

In the present embodiment, the number of nodes 723 in the fully connected layer 713 is equal to the number of nodes 722 in the preceding layer 712. Alternatively, the number of nodes 722, 723 may differ. Furthermore, in the present embodiment, the values of the nodes 724 of the output layer 714 are determined by applying the Softmax function onto the values of the nodes 723 of the preceding layer 713. By applying the Softmax function, the sum of the values of all nodes 724 of the output layer is 1, and all values of all nodes 724 of the output layer are real numbers between 0 and 1. In particular, if using the convolutional neural network 700 for categorizing input data, the values of the output layer may be interpreted as the probability of the input data falling into one of the different categories.

The convolutional neural network 700 may also comprise a ReLU (acronym for "rectified linear units") layer. In particular, the number of nodes and the structure of the nodes contained in a ReLU layer is equivalent to the number of nodes and the structure of the nodes contained in the preceding layer. In particular, the value of each node in the ReLU layer is calculated by applying a rectifying function to the value of the corresponding node of the preceding layer. Examples for rectifying functions are $f(x) = \max(0,x)$, the tangent hyperbolics function or the sigmoid function.

In particular, convolutional neural networks 700 may be trained based on the back-propagation algorithm. To prevent overfitting, methods of regularization may be used, e.g. dropout of nodes 720, ..., 724, stochastic pooling, use of artificial data, weight decay based on the L1 or the L2 norm, or max norm constraints.

In the present embodiment, the convolutional neural network 700 is pretrained based on experimental data, simulation data and test data corresponding to the failure modes. Further, each of the features may be correlated with one or more failure modes using training techniques as explained above.

Advantageously, the present invention computes remaining useful life of the bearing in real-time based on the best-suited virtual model. Therefore, if additional failure modes occur a new best-suited virtual model is selected and updated to estimate the real-time key performance indicators. Furthermore, the present invention also facilitates computing remaining useful life of a plurality of bearings by computing key performance indicators associated with each of the bearings using corresponding best-suited virtual models.

The present invention is not limited to a particular computer system platform, processing unit, operating system, or network. One or more aspects of the present invention may be distributed among one or more computer systems, for example, servers configured to provide one or more services to one or more client computers, or to perform a complete task in a distributed system. For example, one or more aspects of the present invention may be performed on a client-server system that comprises components distributed among one or more server systems that perform multiple functions according to various embodiments. These components comprise, for example, executable, intermediate, or interpreted code, which communicate over a network using a communication protocol. The present invention is not limited to be executable on any particular system or group of system, and is not limited to any particular distributed architecture, network, or communication protocol.

While the invention has been illustrated and described in detail with the help of a preferred embodiment, the invention is not limited to the disclosed examples. Other variations can be deducted by those skilled in the art without leaving the scope of protection of the claimed invention.

## List of reference numerals

| | |
|---|---|
| 100 | system for estimating remaining useful life of a bearing |
| 105 | bearing |
| 110 | apparatus for estimating remaining useful life of a bearing |
| 115 | edge device |
| 120 | network |
| 125 | at least one sensing unit |
| 130 | client device |
| 135 | processing unit |
| 140 | memory unit |
| 145 | storage unit |
| 150 | communication unit |
| 155 | network interface |
| 160 | bus |
| 165 | bearing monitoring module |
| 170 | analysis module |
| 175 | model identification module |
| 180 | life estimation module |
| 185 | notification module |
| 195 | database |
| 200 | ball bearing |
| 210 | outer race |
| 215 | plurality of balls |
| 220 | cage |
| 225 | inner race |
| 410 | first signal processing pipeline corresponding to FFT |
| 415 | second signal processing pipeline corresponding to CWT |
| 420 | third signal processing pipeline corresponding to DWT |
| 500 | signal processing pipeline |
| 505 | CWT function |
| 510 | SK function |
| 515 | bandpass filter |
| 520 | Hilbert Transform function |
| 525 | CWT/FFT function |
| 600 | workflow representing selection of a best-suited virtual model |
| 610 | signal processing pipelines |
| 615 | classification model |
| 620 | virtual models |
| 625 | key performance indicators |
| 700 | convolutional neural network |
| 710 | input layer |
| 711 | convolutional layer |
| 712 | pooling layer |
| 713 | fully connected layer |
| 714 | output layer |

## Claims

1. A computer-implemented method for estimating remaining useful life of a bearing (105), the method comprising:

   receiving, by a processing unit (135), operational data associated with the bearing (105) from at least one source (115, 125) in real-time;
   determining one or more failure modes associated with the bearing (105) based on one or more features associated with the operational data;

identifying a best-suited virtual model corresponding to the bearing (105) from a plurality of virtual models based on the one or more features, wherein each of the virtual models indicates a behavior of the bearing (105) for a predefined set of conditions; and

computing a remaining useful life of the bearing (105) based on the best-suited virtual model.

2. The method according to claim 1, wherein the operational data comprises at least one of temperature signature, vibration signature, current signature and angular velocity associated with the bearing (105).

3. The method according to claim 1, wherein determining the one or more failure modes associated with the bearing (105) based on the at least one feature associated with the operational data, comprises:

analyzing the operational data using a plurality of signal processing pipelines, wherein each of the signal processing pipelines generate a response indicative of the one or more features associated with the operational data; and classifying the one or more features from the response into one or more failure modes using a classification model (700).

4. The method according to claim 1, wherein identifying the best-suited virtual model corresponding to the bearing (105) from the plurality of virtual models comprises:

updating the plurality of virtual models based on the one or more features and corresponding failure modes; generating simulation instances based on each of the updated virtual models; executing the simulation instances in the simulation environment to generate simulation results; and identifying the best-suited virtual model based on the simulation results.

5. The method according to claim 4, wherein identifying the best-suited virtual model based on the simulation results comprises:

computing a reliability coefficient associated with each of the virtual models; and selecting the virtual model corresponding to the highest reliability coefficient as the best-suited virtual model.

6. The method according to claim 1, wherein computing the remaining useful life of the bearing (105) based on the best-suited virtual model comprises:

determining one or more key performance indicators associated with the bearing (105) using the best-suited virtual model; and computing the remaining useful life based on the one or more key performance indicators determined.

7. The method acccording to claim 1 further comprising:
outputting the remaining useful life in real-time on an output device (130).

8. An apparatus (110) for estimating remaining useful life of a bearing (105), the apparatus (110) comprising:

one or more processing units (135); and a memory unit (140) communicatively coupled to the one or more processing units (135), wherein the memory unit (140) comprises a bearing monitoring module (165) stored in the form of machine-readable instructions executable by the one or more processing units (135), wherein the bearing monitoring module (165) is configured to perform method steps according to any of the claims 1 to 7.

9. A system (100) for estimating remaining useful life of a bearing (105), the system (100) comprising:

one or more sources (115, 125) configured for providing operational data associated with the bearing (105); and an apparatus (110) according to claim 8, communicatively coupled to the one or more sources (115, 125), wherein the apparatus (110) is configured for estimating remaining useful life of the bearing (105) based on the operational data, according to any of the method claims 1 to 7.

10. A computer-program product having machine-readable instructions stored therein, which when executed by one or more processing units (135), cause the processing units (135) to perform a method according to any of the claims 1 to 7.

11. A computer-readable storage medium comprising instructions which, when executed by a data-processing system, causes the data-processing system to perform a method according to any of the claims 1 to 7.

# FIG 1A

100

110

120

115

130

125

105

# FIG 1B

# FIG 2A

# FIG 2B

# FIG 3

300

```
┌─────────────┐
│     305     │
└─────────────┘
       │
       ▼
┌─────────────┐
│     310     │
└─────────────┘
       │
       ▼
┌─────────────┐
│     315     │
└─────────────┘
       │
       ▼
┌─────────────┐
│     320     │
└─────────────┘
```

FIG 4

```
                                    ┌──────────┐
                                    │          │
                              ┌────▶│   410    │
                              │     │          │
                              │     └──────────┘
                              │
                              │     ┌──────────┐
    ╭─────────╮               │     │          │
    │    A    │───────────────┼────▶│   415    │
    ╰─────────╯               │     │          │
                              │     └──────────┘
                              │
                              │     ┌──────────┐
                              │     │          │
                              └────▶│   420    │
                                    │          │
                                    └──────────┘
```

FIG 5

500

```
          ┌──────┐
          │  A   │
          └──┬───┘
             │
             ▼
  ┌────────────┐              ┌────────────┐
  │    505     │              │    525     │
  └─────┬──────┘              └─────┬──────┘
        │                          │
        ▼                          ▼
  ┌────────────┐   ┌────────┐  ┌────────────┐
  │    510     │──▶│  515   │─▶│    520     │
  └────────────┘   └────────┘  └────────────┘
```

FIG 6

610A    610B    •  •  •    610N

615

620A    620B    620C    620M

625A    625B    625C    625K

FIG 7

EP 4 160 337 A1

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TOBON-MEJIA D A ET AL: "Estimation of the Remaining Useful Life by using Wavelet Packet Decomposition and HMMs", AEROSPACE CONFERENCE, 2011 IEEE, IEEE, 5 March 2011 (2011-03-05), pages 1-10, XP031938145, DOI: 10.1109/AERO.2011.5747561 ISBN: 978-1-4244-7350-2 * page 1 – page 6; figure 4 * | 1-11 | INV. G05B23/02 G01M13/04 |
| X | BOUMAHDI MOULOUD ET AL: "Analysis and Prediction of Defect Size and Remaining Useful Life of Thrust Ball Bearings: Modelling and Experiment Procedures", ARABIAN JOURNAL FOR SCIENCE AND ENGINEERING, SPRINGER BERLIN HEIDELBERG, BERLIN/HEIDELBERG, vol. 42, no. 11, 27 April 2017 (2017-04-27), pages 4535-4546, XP036338287, ISSN: 2193-567X, DOI: 10.1007/S13369-017-2550-Y [retrieved on 2017-04-27] * page 4536 – page 4544 * | 1-11 | |
| X | EP 3 660 482 A1 (SIEMENS AG [DE]) 3 June 2020 (2020-06-03) * paragraph [0032] – paragraph [0087]; figures 1-3 * | 1-11 | TECHNICAL FIELDS SEARCHED (IPC)  G05B G01M |

The present search report has been drawn up for all claims

| Place of search | Date of completion of the search | Examiner |
|---|---|---|
| Munich | 14 March 2022 | Rakoczy, Tobias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 20 0190

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2022

| Patent document cited in search report | | Publication date | Patent family member(s) | | Publication date |
|---|---|---|---|---|---|
| EP 3660482 | A1 | 03-06-2020 | CN | 113950618 A | 18-01-2022 |
| | | | EP | 3660482 A1 | 03-06-2020 |
| | | | EP | 3870948 A1 | 01-09-2021 |
| | | | US | 2022050015 A1 | 17-02-2022 |
| | | | WO | 2020109561 A1 | 04-06-2020 |

EPO FORM P0459

For more details about this annex : see Official Journal of the European Patent Office, No. 12/82